(19) Europäisches Patentamt

European Patent Office

Office européen des brevets

(11) EP 0 314 510 B1

(12) **EUROPEAN PATENT SPECIFICATION**

(45) Date of publication and mention
of the grant of the patent:
**25.09.1996 Bulletin 1996/39**

(51) Int Cl.⁶: **H03G 3/00**

(21) Application number: **88310193.3**

(22) Date of filing: **28.10.1988**

(54) **Electronic volume device**

Verstärkungsregelungsanlage

Dispositif de contrôle de gain

(84) Designated Contracting States:
**DE FR GB SE**

(30) Priority: **29.10.1987 JP 165985/87**

(43) Date of publication of application:
**03.05.1989 Bulletin 1989/18**

(73) Proprietor: **KABUSHIKI KAISHA TOSHIBA
Kawasaki-shi, Kanagawa-ken 210 (JP)**

(72) Inventors:
• **Sakanishi, Masayuki c/o Patent division
Tokyo (JP)**
• **Ishii, Takaaki c/o Patent division
Tokyo (JP)**

(74) Representative: **Freed, Arthur Woolf et al
MARKS & CLERK,
57-60 Lincoln's Inn Fields
London WC2A 3LS (GB)**

(56) References cited:
**FR-A- 2 384 384          FR-A- 2 497 033**

• **ELECTRONICS, vol. 40, no. 20, 2nd October
1967, page 99, McGraw-Hill, New York, US; D.
LANCASTER: "Operational amplifier gain varied
by FET chopper"**
• **PATENT ABSTRACTS OF JAPAN, vol. 6, no. 81
(E-107)[959], 19th May 1982; JP-A-57**
• **017 213 (NIPPON GAKKI SEIZO K.K.) 28 January
1982**

## Description

This invention relates to an electronic volume device of a chopper type which controls the quantity of attenuation of an input analog signal to the device by switching the analog signal at predetermined periods and, more particularly, to an electronic volume device which is intended to miniaturize the device and to reduce the cost of the device by using a switching control unit which can be composed of a monolithic LSI (Large Scale Integration).

An electric volume device of a chopper type has been proposed in FR-2384384 (Hughes). In this device two analog CMOS-gates are used, one on a signal path and one from the signal path to ground.

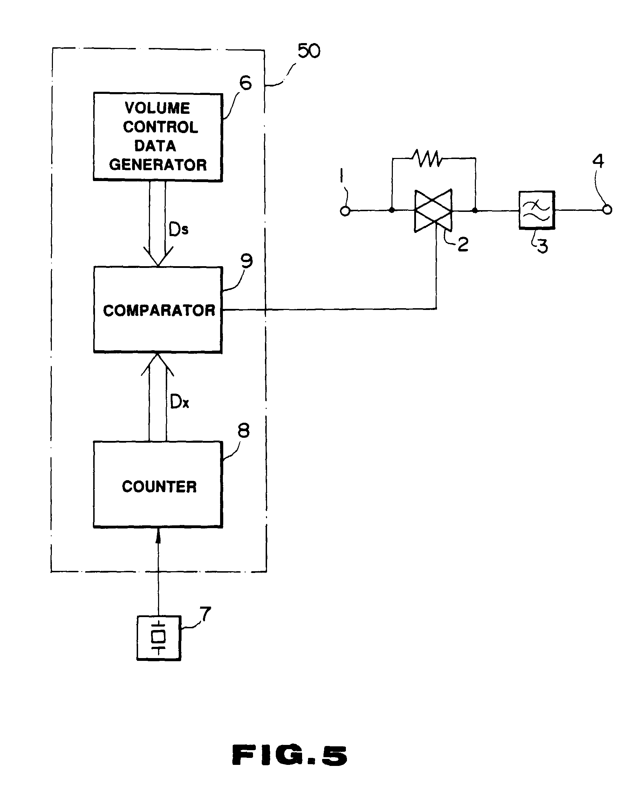

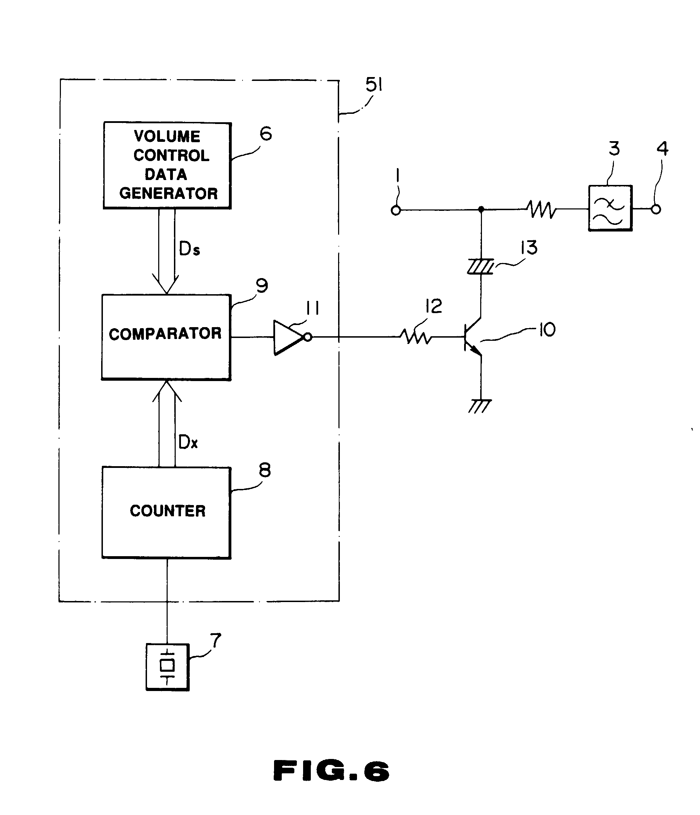

Other electric volume devices of a chopper type which have been proposed are shown in Fig. 5 and 6. In the device of Fig. 5, an input analog signal received at an input terminal 1 is turned on and off by an analog switch 2, the output of which is supplied via a low pass filter 3 for removing useless higher harmonics to an output terminal 4 from which the signal appears attenuated by a predetermined quantity. The switch 2 is turned on and off by a switching control signal input to the gate of the switch 2. Thus the duty cycle of the switching control signal is changed to change a quantity of attenuation of the signal output from the output terminal 4.

The switching control signal applied to the gate terminal of the analog switch 2 is formed by a volume control circuit 50. The volume control circuit 50 includes a volume control data generator 6 which generates a volume control data $D_s$ corresponding to a desired quantity of attenuation, a counter 8 which counts clock signals generated by a clock generation source 7 and having a predetermined frequency and which outputs a numerical data signal $D_x$ which changes periodically, and a comparator 9 which compares the volume control data $D_s$ output by the volume control data generator 6 and the numerical data $D_x$ output by the counter 8 and outputs, for example, a high level signal when $D_s > D_x$ and a low level signal when $D_s \leqq D_x$. The output signal from the comparator 9 is applied to the gate of the analog switch 2 as the switching control signal.

In such arrangement, the period of the switching control signal output by the volume control circuit 50 is determined by the repeated counting period of counter 8, and the the duty cycle of the switching control signal is determined by the value of the volume control data $D_x$ set in the volume control data generator 6. When the volume control data $D_s$ set in the volume control data generator 6 of the volume control circuit 50 increases, the duty cycle of the switching control signal output by the volume control circuit 50 increases, so that the conductivity of the analog switch 2 increases to thereby reduce the quantity of attenuation of the input analog signal. In contrast, when the volume control data $D_s$ set in the volume control data generator 6 decreases, the duty cycle of the switching control signal ouput by the volume control circuit 50 decreases to thereby reduce the conductivity of the analog switch 2, and hence increase the quantity of attenuation of the input analog signal.

The structure of Fig. 6 employs a transistor 10 and a capacitor 12 instead of the analog switch 2 in Fig. 5. In this case, the switching control signal output by the comparator 9 of the volume control circuit 51 is applied to the base of the transistor 10 via an invertor 11, thereby controlling the quantity of attenuation of the analog signal as in the example of Fig. 5.

In such electronic volume device, the volume control circuit 50 or 51 can be fabricated as an integrated circuit. For example, it may be fabricated from a MOS (Metal Oxide Semiconductor) LSI (Large Scale Integration), a CMOS (Complementary Metal Oxide Semiconductor) gate array LSI or a bipolar type gate array LSI. Therefore, the volume control circuit of the electronic volume device can be miniaturized and lightened. However, the circuit parts inclusive of the analog switch 2 shown in Fig. 5 or the transistor 10 shown in Fig. 6 as switching means is difficult to be constituted as a monolithic LSI, so that it requires many circuit parts, which is a big hindrance in the miniaturisation, lightening, and costs reduction of the electronic volume device.

As described above, in the electronic volume circuit as shown in FR-2384384 and in Figs. 5 and 6, the circuit parts inclusive of the switching means cannot be constituted as a monolithic LSI, so that it requires many circuit parts and is a hindrance in the miniaturisation, lightening and cost reduction of the volume circuit.

In view of such situations, it is an object of the present invention to provide an electronic volume device which reduces the number of parts used, and realizes miniaturisation, lightening and cost reduction of the volume device.

According to the present invention as defined by the appended independent claim and with advantageous embodiments described in the appended dependent claims, the electronic volume device, inclusive of switching means which switches an input analog signal, is constituted by a monolithic LSI.

According to the inventive electronic volume device, the on/off switching of an analog signal is substantially performed by elements incorporated into the LSI, so that the number of parts used is reduced, and miniaturization, lightening and cost reduction of the device are realized.

Fig. 1 is a block diagram showing one embodiment of an electronic volume device according to the present invention;
Fig. 2 is a circuit diagram showing one example of a buffer shown in Fig. 1;
Fig. 3 is a circuit diagram showing another example of the buffer shown in Fig. 1;
Fig. 4 is a waveform showing the operation of the embodiment shown in Fig. 1; and
Fig. 5 and 6 each are a block diagram showing an example of a electronic volume device of a chopper type.

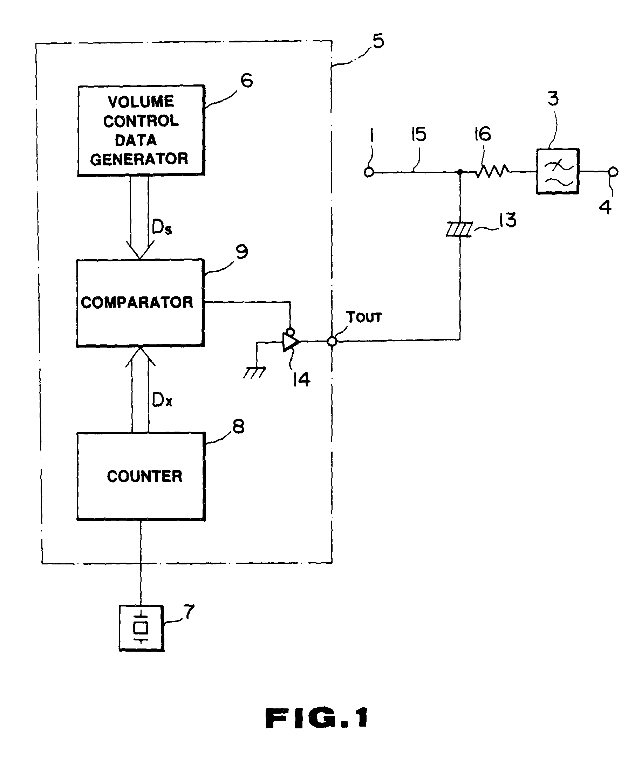

One embodiment of the present invention will now be described in detail with reference to the accompanying drawings. Like reference numerals are given to like components throughout in Figs. 1, 5 and 6 for convenience of description and further description thereof will be omitted.

In Fig. 1, an analog signal to be controlled is applied to an input terminal 1. The signal applied to the input terminal 1 is applied to a low pass filter 3 via a signal line 15 and a resistor 16. The signal line 15 is connected to a signal output terminal $T_{out}$ of a volume control circuit 5 via a capacitor 13.

The volume control circuit 5 includes a volume control data generator 6, a counter 8, a comparator 9 and a buffer 14. Volume control data $D_s$ corresponding to a desired quantity of attenuation is set in the volume control data generator 6 which outputs a signal indicative of the volume control data $D_s$. The counter 8 counts clock signals having predetermined period generated by a clock source 7 and outputs a signal indicative of the numerical data $D_x$ corresponding to the counts. If the counter 8 is, for example, of a 5 bit type (in this case, the volume control data $D_s$ set in the volume control data generator 6 is also of a 5-bit type), the measured data $D_x$ starts to increment from "00000". When the data exceeds "11111", it again becomes "00000" and repeats such behavior. The comparator 9 compares the signal indicative of the volume control data $D_s$ output by the volume control data generator 6 and the signal indicative of the numerical $D_x$ output by the counter 8. When $D_s > D_x$, the comparator 9 outputs a high level switching control signal while when $D_s \leqq D_x$, the comparator outputs a low level switching control signal. The switching control signal is then applied to the control input of the buffer 14.

When the switching control signal is at high level, the buffer 14 output is switched to a high impedance state; namely, its output terminal $T_{out}$ is switched to a floating state. When the switching control signal is at low level, the buffer output is switched to a low impedance state; namely, its output terminal $T_{out}$ is switched to a grounded state. The buffer 14 may be constituted by a tri-state buffer or an open drain buffer.

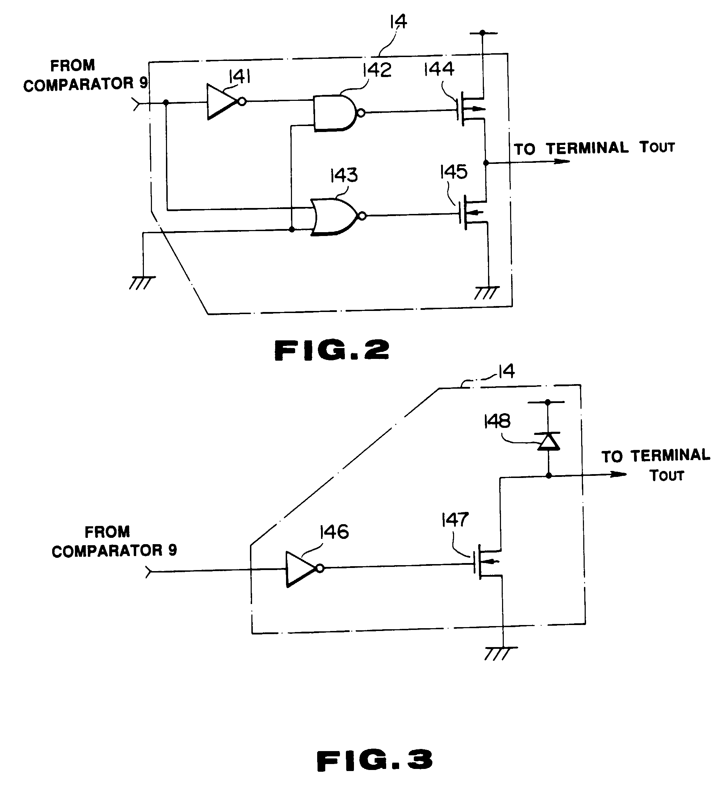

The volume control circuit 5 may be constituted, for example, by a monolithic CMOS gate array LSI. In that case, the specific circuit example of the buffer 14 is shown in Fig. 2, and constitutes a tri-state buffer which includes an inverter 141, a NAND gate 142, an OR gate 143 and a p-channel FET (Field Effect Transistor) 144 and n-channel FET 45 each being composed of a monolithic CMOS circuit. In the circuit of Fig. 2, when the signal from the comparator 9 is at high level, the p-channel FET 144 is off, the n-channel FET 145 is also off, and the terminal $T_{out}$ is in a high impedance state or in a floating state. When the signal from the comparator 9 is at low level, the p-channel FET 144 is off, n-channel FET 145 is on and the terminal $T_{out}$ is in a low impedance state or in a grounded state.

Fig. 3 illustrates the buffer 14 constituted as an open drain buffer. It includes an invertor 146, a FET 147 and a diode 148. If the signal from the comparator 9 is at high level, FET 147 is turned off, the terminal Tout is in a high impedance state or in a floating state. If the signal from the comparator 9 is at low level, FET 147 is turned on and the terminal $T_{out}$ is in a low impedance state or in a grounded state.

When the signal output terminal $T_{out}$ of the volume control circuit 5 is in a high impedance state or in a floating state, the controlled analog signal applied to the input terminal 1 is intactly applied to the low pass filter 3 via the signal line 15 and resistor 16. However, if the output terminal $T_{out}$ of the volume control circuit 5 is in a low impedance or in a grounded state, the signal on the signal line 15 is grounded via the capacitor 13, terminal $T_{out}$, and buffer 14, so that the controlled analog signal applied to the input terminal 1 is not applied to the low pass filter 3.

As just described, the controlled analog signal applied to the input terminal 1 is turned on/off and then applied to the low pass filter 3 depending on whether the signal output terminal $T_{out}$ of the volume control circuit 5 is in a high impedance state or in a low impedance state. The low pass filter 3 eliminates high frequency components from the on/off-controlled analog signal to form a smoothly changing output signal. The signal passing through the low pass filter 3 is output as an output signal from the output terminal 4.

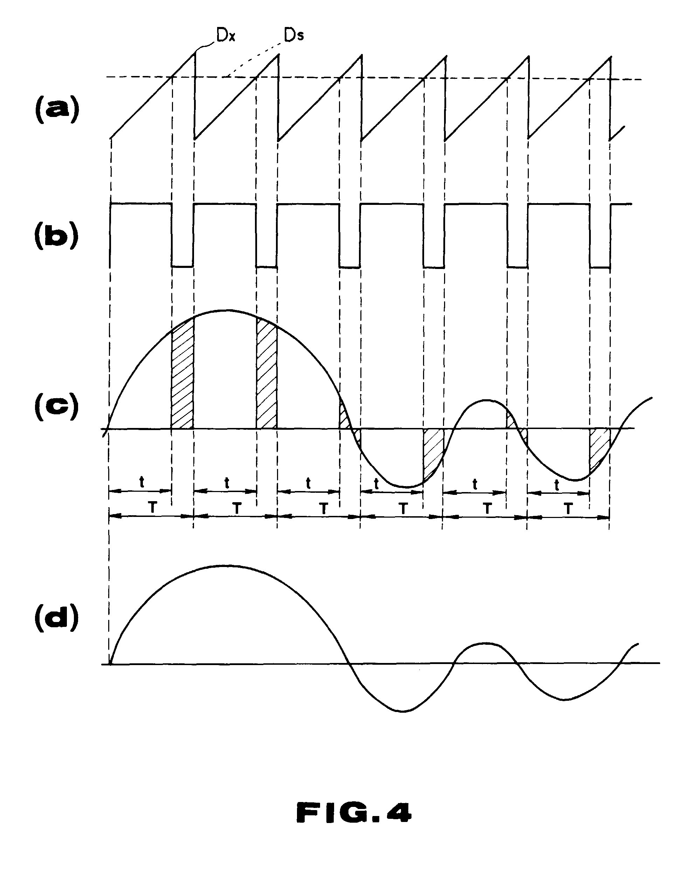

Fig. 4 shows the state and waveforms of signals at several elements of the embodiment shown in Fig. 1. Fig. 4(a) shows the relationship between numerical data $D_x$ output by the counter 8 and volume control data $D_s$ output by the volume control data generator 6. In Fig. 4 (a), the solid line shows the numerical data $D_x$ and the broken line shows the volume control data $D_s$.

Fig. 4(b) illustrates the switching control signal output by the comparator 9 in conjunction with Fig. 4(a). The switching control signal shown in Fig. 4(b) is at high level when $D_s > D_x$ and at low level when $D_s \leqq D_x$ in Fig. 4(a). Fig. 4(c) shows the waveform of signals applied to the input terminal 1 and to the low pass filter 3. In Fig. 4(c), the solid line shows the signal applied to the input terminal 1 while the hatching shows zero portions in the signal caused by the low impedance state 5.

Fig. 4(d) illustrates the smooth waveform converted by the low pass filter 3. As will be obvious from this signal, the low pass filter 3 outputs a signal whcih includes the signal applied to the input terminal 1 and shown in Fig. 4(c) and attenuated by a quantity corresponding to the duty cycle of the switching control signal shown in Fig. 4(b).

The duty cycle D is given by

$$D = t/T$$

where t is the switching on time during which the signal output terminal $T_{out}$ of the volume control circuit 5 is in the "high impedance state" in which the analog signal is applied to the low pass filter 3, and T is the period of the signal output from the signal output terminal $T_{out}$ of the volume control circuit 5.

The value of the analog signal integrated during the switching on time t constitutes the transmitted power output from the output terminal 4 via the low pass filter 3. The transmitted power is smoothed by the low pass filter 3 as shown in Fig. 4(d) and output from the output terminal 4.

Therefore, by controlling the value of the duty cycle D, the quantity of power or the quantity of attenuation of the analog signal output from the output terminal 4 is controlled.

**Patentansprüche**

1. Elektronische Tonsignalpegel-Vorrichtung mit:

einer Signalleitung (15), über die ein analoges Eingangssignal von einem Eingang (1) angelegt wird;

einem Tiefpaßfilter (3), das mit der Signalleitung verbunden ist, zur Bildung eines Ausgangssignals durch Beseitigung von hochfrequenten Komponenten aus dem Signal in der Signalleitung; und

einer Tonsignalpegelregelungsschaltung (5);

dadurch gekennzeichnet, daß die Tonsignalpegelregelungsschaltung (5) durch eine monolithische integrierte Schaltung gebildet wird und einen Signalanschluß ($T_{out}$) aufweist, der mit der Signalleitung (15) verbunden ist, ohne daß die Tonsignalpegelregelungsschaltung (5) zwischen den Eingang (1) und das Tiefpaßfilter (3) geschaltet ist, wobei die Tonsignalpegelregelungsschaltung (5) ferner aufweist: eine Schaltsteuersignalerzeugungseinrichtung (6, 8, 9) zum Erzeugen eines Schaltsteuersignals mit einem Tastverhältnis, das einem gewünschten Dämpfungsverhältnis entspricht, und eine Einrichtung (14) zum Schalten des Signalanschlusses ($T_{out}$) zwischen einen erdfreien Zustand und einen geerdeten Zustand entsprechend dem Schaltsignal, das von der Schaltsteuereinrichtung erzeugt wird;

eine Einrichtung (13) zum Verbinden des Signalanschlusses ($T_{out}$) der Tonsignalpegelregelungsschaltung mit der Signalleitung vorgesehen ist;

wobei die Tonsignalpegelregelungsschaltung (5) durch eine monolithische Großintegration gebildet wird, bei der die Schaltsteuersignalerzeugungseinrichtung (6, 8, 9) und die Schalteinrichtung (14) jeweils durch die gleiche monolithische Großintegration gebildet wird und die Schalteinrichtung (14) durch einen offenen Drain-Puffer oder einen Drei zustandspuffer unter Verwendung ei ner monolithischen Groß integrati on mit einer MOS-Struktur gebildet wird.

2. Elektronische Tonsignalpegel-Vorrichtung nach Anspruch 1, bei der die Schaltsteuersignalerzeugungseinrichtung (6, 8, 9) aufweist:

einen Tonsignalpegelsteuerdatengenerator (6), in dem die Tonsignalpegelsteuerdaten eingestellt werden, die einer gewünschten Dämpfungsgröße entsprechen;

eine Einrichtung (8) zum Zählen von vorbestimmten Takten, um ein sich periodisch änderndes numerisches Signal zu erzeugen; und

eine Einrichtung (9) zum Vergleichen der Tonsignalpegelsteuerdaten, die im Tonsignalpegelsteuerdatengenerator eingestellt werden, und des numerischen Signals, das von der Zähleinrichtung erzeugt wird, um das Schaltsteuersignal zu bilden.

3. Elektronische Tonsignalpegel-Vorrichtung nach Anspruch 1, bei der die Verbindungseinrichtung (13) den Signalanschluß ($T_{out}$) der Tonsignalpegelregelungsschaltung mit der Signalleitung verbindet, über die das analoge Eingangssignal über einen Kondensator angelegt wird.

4. Elektronische Tonsignalpegel-Vorrichtung nach Anspruch 1, bei der die Schalteinrichtung (14) einen Dreizustandspuffer aufweist.

5. Elektronische Tonsignalpegel-Vorrichtung nach Anspruch 1, bei der die Schalteinrichtung (14) einen offenen Drain-Puffer aufweist.

6. Elektronische Tonsignalpegel-Vorrichtung nach Anspruch 1, bei der die Tonsignalpegelregelungsschaltung (5) durch eine monolithische Großintegration mit einer MOS-Struktur gebildet wird.

7. Elektronische Tonsignalpegel-Vorrichtung nach Anspruch 6, bei der die Tonsignalpegelregelungsschaltung (5) durch eine Gatteranordnung in Großintegration gebildet wird.

## Claims

1. An electronic volume device comprising:

a signal line (15) through which an input analog signal is applied from an input (1);
a low pass filter (3) connected to the signal line for forming an output signal by eliminating high frequency components from the signal on the signal line; and
a volume control circuit (5);

characterized in that said volume control circuit (5) is constituted by a monolithic integrated circuit and having a signal terminal (Tout) connected to said signal line (15) without the volume control circuit (5) being interposed between the input (1) and the low pass filter (3), said volume control circuit (5) further includes switching control signal generating means (6, 8, 9) for generating a switching control signal having a duty cycle corresponding to a desired proportion of attenuation, and means (14) for switching the signal terminal (Tout) between a floating state and a grounded state in accordance with the switching signal generated by the switching control generating means;

means (13) is provided for connecting the signal terminal (Tout) of the volume control circuit to the signal line;
the volume control circuit (5) being constituted by a monolithic large scale integration, wherein the switching control signal generating means (6, 8, 9) and switching means (14) each are constituted by a same monolithic large scale integration and the switching means (14) is constituted by an open drain buffer or tri-state buffer using a monolithic large scale integration having a MOS structure.

2. An electronic volume device according to claim 1, wherein the switching control signal generating means (6, 8, 9) includes:

a volume control data generator (6) in which volume control data corresponding to a desired quantity of attenuation is set;
means (8) for counting predetermined clocks to generate a periodically changing numerical signal; and
means (9) for comparing the volume control data set in the volume control data generator and the numerical signal generated by the counting means to form the switching control signal.

3. An electronic volume device according to claim 1, wherein the connecting means (13) connects the signal terminal (Tout) of the volume control circuit to the signal line through which the input analog signal is applied via a capacitor.

4. An electronic volume device according to claim 1, wherein the switching means (14) includes a tri-state buffer.

5. An electronic volume device according to claim 1, wherein the switching means (14) includes an open drain buffer.

6. An electronic volume device according to claim 1, wherein the volume control circuit (5) is constituted by a monolithic large scale integration of a MOS structure.

7. An electronic volume device according to claim 6, wherein the volume control circuit (5) is constituted by a gate array of large scale integration.

## Revendications

1. Dispositif électronique de commande de volume comprenant:

une ligne de signal (15) par l'intermédiaire de laquelle un signal analogique d'entrée est appliqué depuis une entrée (1);

un filtre passe-bas (3) connecté à la ligne de signal pour former un signal de sortie en éliminant des composantes haute fréquence du signal sur la ligne de signal; et

un circuit de commande de volume (5),

caractérisé en ce que ledit circuit de commande de volume (5) est constitué par un circuit intégré monolithique et comporte une borne de signal ($T_{out}$) connectée à ladite ligne de signal (15) sans que le circuit de commande de volume (5) ne soit interposé entre l'entrée (1) et le filtre passe-bas (3), ledit circuit de commande de volume (5) incluant en outre un moyen de génération de signal de commande de commutation (6. 8, 9) pour générer un signal de commande de commutation présentant un rapport cyclique correspondant à une proportion souhaitée d'atténuation, et un moyen (14) pour commuter la borne de signal ($T_{out}$) entre un état flottant et un état de mise à la masse conformément au signal de commutation généré par le moyen de génération de commande de commutation;

un moyen (13) est prévu pour connecter la borne de signal ($T_{out}$) du circuit de commande de volume à la ligne de signal;
le circuit de commande de volume (5) étant constitué au moyen d'une intégration à grande échelle monolithique où le moyen de génération de signal de commande de commutation (6. 8, 9) et le moyen de commutation (14) sont chacun constitués au moyen d'une même intégration à grande échelle monolithique et le moyen de commutation (14) est constitué par un tampon à drains déconnectés ou par un tampon à trois états qui utilise une intégration à grande échelle monolithique présentant une structure MOS.

2. Dispositif électronique de commande de volume selon la revendication 1. dans lequel le moyen de génération de signal de commande de commutation (6, 8, 9) inclut:

un générateur de données de commande de volume (6) dans lequel des données de commande de volume correspondant à une quantité souhaitée d'atténuation sont établies;

un moyen (8) pour compter des horloges prédéterminées afin de générer un signal numérique variant périodiquement; et

un moyen (9) pour comparer les données de commande de volume établies dans le générateur de données de commande de volume et le signal numérique généré par le moyen de comptage afin de former le signal de commande de commutation.

3. Dispositif électronique de commande de volume selon la revendication 1, dans lequel le moyen de connexion (13) connecte la borne de signal ($T_{out}$) du circuit de commande de volume à la ligne de signal par l'intermédiaire de laquelle le signal analogique d'entrée est appliqué via un condensateur.

4. Dispositif électronique de commande de volume selon la revendication 1, dans lequel le moyen de commutation (14) inclut un tampon à trois états.

5. Dispositif électronique de commande de volume selon la-revendication 1, dans lequel le moyen de commutation (14) inclut un tampon à drains déconnectés.

6. Dispositif électronique de commande de volume selon la revendication 1, dans lequel le circuit de commande de volume (5) est constitué au moyen d'une intégration à grande échelle monolithique d'une structure MOS.

7. Dispositif électronique de commande de volume selon la revendication 6, dans lequel le circuit de commande de volume (5) est constitué par un réseau prédiffusé à intégration à grande échelle.

**FIG.1**

**FIG.2**

**FIG.3**

**FIG. 4**

**FIG.5**

FIG.6